# NEUE EUROPÄISCHE PATENTSCHRIFT

(11) **EP 1 672 690 B2**
(45) Veröffentlichungstag und Bekanntmachung des Hinweises auf die Entscheidung über den Einspruch: **30.10.2024**
(45) Hinweis auf die Patenterteilung: 15.06.2011
(21) Anmeldenummer: 04030201.0
(22) Anmeldetag: 20.12.2004
(51) Int. Cl.: H01L 23/473, H01S 5/024, H01S 5/40

(54) **Mikrokühlkörper**
Micro heat sink
Microdissipateur thermique

(43) Veröffentlichungstag der Anmeldung: 21.06.2006
(73) Patentinhaber: IQ evolution GmbH, 52074 Aachen (DE)
(72) Erfinder: Ebert, Dr. Thomas, 52072 Aachen (DE)
(74) Vertreter: Paul, Dieter-Alfred

(56) Entgegenhaltungen:
- EP-A2- 1 211 730
- EP-B1- 1 555 079
- EP-B1- 1 716 624
- DE-A1- 19 506 091
- DE-A1- 4 315 580
- US-A- 4 859 520
- US-A- 5 086 333
- US-A- 5 263 251
- US-A- 5 548 605
- US-B1- 6 578 626
- Dirk Lorenzen: Methoden zur verlässigkeitsorientierten Optimierung der Aufbau- und Verbindungstechnik von Hochleistungs-Diodenlaserbarren", Verlag Dr. Köster, Berlin,Oktober 2003, Seiten 2, 3, 6, 7, 30, 31,38, 39, 154 und 155;
- IMAPS Strasbourg 2001 "Innovative Cooling Concept for Highly Integrated Avionics Modules", Dr. Jürgen Schulz-Harder et al

## Beschreibung

Die vorliegende Erfindung betrifft einen Mikrokühlkörper mit einer Montagefläche für ein zu kühlendes Bauteil, insbesondere ein Halbleiterbauelement, welcher insbesondere quaderartig ausgebildet ist und im Inneren eine Mikrokühlstruktur aufweist, die über Verbindungskanäle mit mindestens einer Zulauföffnung und mindestens einer Ablauföffnung verbunden ist, und mit diesen einen innerhalb des Mikrokühlkörpers ausgebildeten Kühlkreislauf bilden, über den der Mikrostruktur ein Kühlmedium zuführ- bzw. aus ihr abführbar ist. Weiterhin betrifft die Erfindung ein Diodenlaserbauelement mit einem aufgelöteten Diodenlaser bzw. einen Diodenlaserstack, die solche Mikrokühlkörper aufweisen, sowie ein Verfahren zur Herstellung eines Mikrokühlkörpers.

Mikrokühlkörper der oben genannten Art sind aus der US 5 548 606 A bekannt.

Mikrokühlkörper der oben genannten Art sind bekannt und beispielsweise in der DE 4 315 580 A1 beschrieben. Die Mikrokühlkörper bestehen aus einer Vielzahl von einzelnen Lagen bzw. Schichten strukturierter, etwa 300 µm starker Kupferfolien.

Zur Herstellung des Mikrokühlkörpers werden die Kupferfolien in geeigneter Weise derart übereinander geschichtet, daß die in die Kupferfolien beispielsweise geätzten oder gestanzten Strukturen einen Kühlkreislauf mit einer Mikrokühlstruktur, Verbindungskanälen und einem Zu- und Ablauf bilden.

Anschließend werden die Kupferfolien durch Direct Copper Bonding miteinander verbunden. Dazu werden an den Oberflächen der Kupferschichten Oxidschichten ausgebildet, die anschließend miteinander verschweißt werden.

Im Betrieb wird der schichtförmig aufgebaute Mikrokühlkörper mit einem Kühlmedium wie beispielsweise deionisiertem Wasser durchströmt. Der Einsatz von deionisiertem Wasser als Kühlmedium wird als vorteilhaft angesehen, da es nur eine geringe Wechselwirkung mit dem Material des Mikrokühlkörpers zeigt.

Beim Direct Copper Bonding wird als problematisch angesehen, daß die zwischen den Oxidschichten gebildeten Verbindungen eine geringe Dichtigkeit aufweisen, so daß der Mikrokühlkörper eine Mindestwandstärke von 400 µm aufweisen muß, um ein Mindestmaß an Sicherheit vor einer Leckage des Mikrokühlkörpers zu gewährleisten.

Weiterhin ist aufgrund der Oxidschichten und dadurch, daß die den kühlkreislauf bildenden Strukturen in die Kupferfolien größtenteils geätzt werden, der Mikrokühlkörper korrosionsanfällig.

Zur Vermeidung dieser Korrosion wird im Stand der Technik vorgeschlagen, Passivierungsschichten beispielsweise aus Nickel auf die Kupferschichten aufzubringen. Jedoch wird durch die Strömung des deionisierten Wassers in dem Mikrokühlkörper die Passivierungsschicht insbesondere an scharfen Kantenbereichen abgetragen und von dem deionisierten Wasser aufgenommen. Die so in das deionisierte Wasser eingebrachten Ionen können dabei als eine Art "Abbaukatalysator" wirken. Die Folge ist eine ggf. sogar beschleunigte Korrosionsanfälligkeit des an den abgetragenen Bereichen freiwerdenden Kupfers.

Ein weiteres Problem bei der Verwendung von Mikrokühlkörpern aus Kupfer besteht darin, daß Kupfer einen Wärmeausdehnungskoeffizienten von ungefähr 17 besitzt, wohingegen ein auf den Mikrokühlkörper aufzulötendes Bauteil wie beispielsweise ein Hochleistungsdiodenlaser aus Galliumarsenit einen Wärmeausdehnungskoeffizienten von ungefähr 6,5 aufweist. Aufgrund der unterschiedlichen Wärmeausdehnungskoeffizienten können Spannungen und Verzug zwischen dem Mikrokühlkörper und dem jeweils aufgelöteten Bauteil auftreten.

Zur Lösung dieses Problems schlägt das Dokument DE 195 06 091 A1 vor, zwischen den einzelnen Kupferschichten Keramikschichten vorzusehen und die Kupferschichten und die Keramikschichten jeweils unter Verwendung der Direct-Copper-Bonding-Technik flächig miteinander zu verbinden. Die Keramikschichten werden dazu an ihren außen liegenden Seiten mit einer Kupferschicht versehen, wobei auf der obersten Schicht ein zu kühlendes Bauteil, hier einen Diodenlaser, angeordnet ist. Unterhalb der Diodenlaseranordnung ist in der Keramikschicht zur Verbesserung der Wärmeleitfähigkeit ein Einsatz oder eine vergrabene Schicht aus einem Material mit extrem hoher Wärmeleitfähigkeit, beispielsweise Diamant oder T-cBN, eingebracht. Durch die Verwendung der Keramikschichten soll gewährleistet werden, daß das Substrat gegenüber einem Substrat oder Kühlkörper, welcher ausschließlich aus Metall und insbesondere aus Kupfer besteht, einen stark reduzierten Wärmeausdehnungskoeffizienten aufweist.

Bei der aus dem Dokument DE 195 06 091 A1 bekannten Anordnung geht aufgrund der verwendeten Oxidschichten wie oben bereits erläutert sowohl ein Dichtigkeitsproblem als auch ein Korrosionsproblem einher. Ferner können auch zwischen den Kupfer- und Keramikschichten Eigenspannungen auftreten, die ebenfalls zu einer Leckage führen können.

Es ist daher Aufgabe der vorliegenden Erfindung, einen Mikrokühlkörper sowie ein Verfahren zu dessen Herstellung bereitzustellen, die eine Verringerung der Mindestaußenwandstärken des Mikrokühlkörpers ermöglichen, um eine verbesserte Wärmeabfuhr im Bereich der Montageflächen für elektronische Bauteile zu erreichen, ohne dabei eine Verringerung der Leckagesicherheit des Mikrokühlkörpers in Kauf nehmen zu müssen.

Diese Aufgabe wird erfindungsgemäß durch einen Mikrokühlkörper wie im Anspruch 1 beschrieben gelöst, welcher eine monolithische Struktur aufweist.

Mit anderen Worten basiert die Erfindung auf dem Grundgedanken, daß durch die Vermeidung von Fugen, wie sie in schichtförmig aufgebauten Mikrokühlkörpern vorhanden sind, das Dichtigkeitsproblem verringert wird. Dies wird erreicht, indem ein monolithischer Mikrokühlkörper hergestellt wird. Durch die monolithische Struktur des Mikrokühlkörpers ist es möglich, die benötigte Mindestaußenwandstärke des Mikrokühlkörpers gegenüber den Wandstärken der bekannten Kupferwärmesenken stark zu verringern, so daß eine wesentlich größere Überdeckung zwischen dem Bereich, durch den ein Kühlmedium, beispielsweise deionisiertes Wasser, für einen Wärmeaustausch fließen kann und dem Bereich, in dem die elektronischen Bauelemente aufgelötet sind, erreicht wird.

Zweckmäßigerweise wird der erfindungsgemäße Mikrokühlkörper mittels des selektiven Laserschmelzens hergestellt. Durch das Verfahren des selektiven Laserschmelzens wird es möglich, beliebige monolithische, dreidimensionale Formen und Strukturen innerhalb des Mikrokühlkörpers zu erzeugen.

In dem erfindungsgemäßen Mikrokühlkörper können Außenwandstärken < 400 µm realisiert werden, insbesondere Außenwandstärken von ungefähr 100 µm, so daß auch der Temperaturgradient innerhalb der aufgelöteten elektronischen Bauelemente selbst verringert wird.

Die vorliegende Erfindung sieht vor, den Mikrokühlkörper aus Edelstahl oder Molybdän auszubilden. Aufgrund der Korrosionsbeständigkeit des Edelstahls wird die Gefahr von Korrosion und folglich einer durch die Korrosion hervorgerufenen Leckage des Mikrokühlkörpers vermindert, so daß die Mindestaußenwandstärke entsprechend gering gehalten werden kann. Durch den hieraus folgenden verbesserten Wärmeaustausch im Überdeckungsbereich zwischen Mikrokühlkörper und elektrischem Bauelement wird die gegenüber Kupfer an sich schlechtere Wärmeleitfähigkeit des Edelstahls ausgeglichen.

Um eventuell entstehende Eigenspannungen zwischen den elektronischen Bauteilen und dem Mikrokühlkörper aufgrund der unterschiedlichen Wärmeausdehnungskoeffizienten zu verringern, schlägt die Erfindung vor, den Mikrokühlkörper aus einem an den Wärmeausdehnungskoeffizienten des zu kühlenden Bauteils angepaßten Material auszubilden. Im Falle eines zu kühlenden Bauteiles aus Galliumarsenit mit einem Wärmeausdehnungkoeffizienten von ungefähr 6,5 wird Molybdän mit einem Wärmeausdehnungskoeffizienten von ungefähr 5 als Material für den Mikrokühlkörper gewählt werden.

Um den Kühleffekt im Überdeckungsbereich des elektronischen Bauteils mit dem Mikrokühlkörper weiter zu steigern, kann die Mikrokühlstruktur derart ausgeführt sein, daß sich darin eine turbulente Strömung ausbildet, wodurch eine verbesserte Kühlleistung erreicht wird.

Die Mikrokühlstruktur kann in geringem Abstand zueinander angeordnete kammförmige Fortsätze aufweisen. Durch die geringen Abstände der kammförmigen Fortsätze zueinander können sich die dadurch nahe beieinanderliegenden Grenzflächen auch untereinander beeinflussen, was wiederum zu einer verbesserten Kühlwirkung führt.

Gemäß einem weiteren Ausführungsbeispiel der Erfindung weisen die Verbindungskanäle eine strömungsoptimierte Struktur, insbesondere in Form von abgerundeten insbesondere ovalen Innenwandungen und Grenzflächen auf, so daß sich in den Verbindungskanälen eine nahezu laminare Strömung ausbildet. Eine laminare Strömung ist im Bereich der Verbindungskanäle wünschenswert, um Druckabfall im Kühlmedium während des Durchströmens des Mikrokühlkörpers möglichst gering zu halten.

Die erfindungsgemäßen Mikrokühlkörper können auch in sogenannten Diodenlaserstacks zur Kühlung der darin befindlichen Diodenlaser eingesetzt werden. Für diese Anwendung ist es vorteilhaft, den Mikrokühlkörper quaderförmig auszuführen, da die erfindungsgemäßen Mikrokühlkörper in den Stacks übereinander gestapelt werden. Die quaderförmigen Mikrokühler bilden jeweils eine ebene Auflägefläche für den darüber zu stapelnden Mikrokühler, sodaß sich eine stabile Verbindung zwischen den einzelnen Mikrokühlern herstellen läßt. Die Zulauf- bzw. Ablauföffnungen der einzelnen Mikrokühlkörper werden zum Betrieb des Stacks an einen in dem Stack ausgebildeten gemeinsamen Zulaufkanal sowie einen gemeinsamen Ablaufkanal für das Kühlmedium angeschlossen.

Hinsichtlich weiterer vorteilhafter Ausgestaltungen und Weiterbildungen der Erfindung wird auf die Unteransprüche sowie die nachfolgende Beschreibung eines Ausführungsbeispiels anhand der beiliegenden Zeichnung verwiesen. In der Zeichnung zeigt:
- Figur 1: eine perspektivische Darstellung eines erfindungsgemäßen Mikrokühlkörpers;
- Figur 2: einen Längsschnitt durch einen Mikrokühlkörper gemäß der Figur 1 um 180° gedreht;
- Figur 3: eine perspektivische Darstellung einer in dem Mikrokühlkörper gemäß der Figur 1 ausgebildeten Kühlkreislauf von oben; und
- Figur 4: eine perspektivische Darstellung des Kühlkreislaufs aus der Figur 3 von unten.

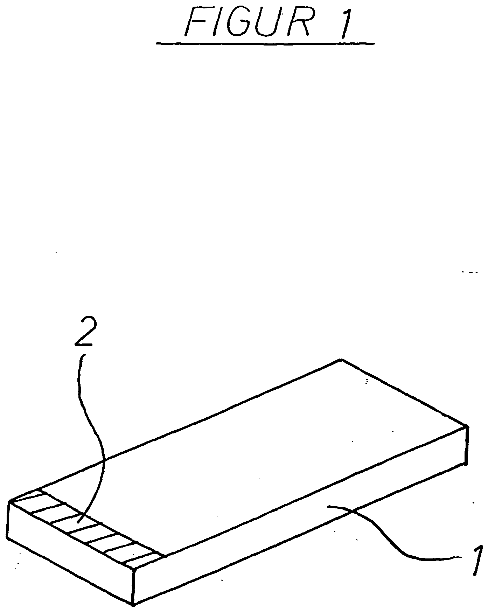

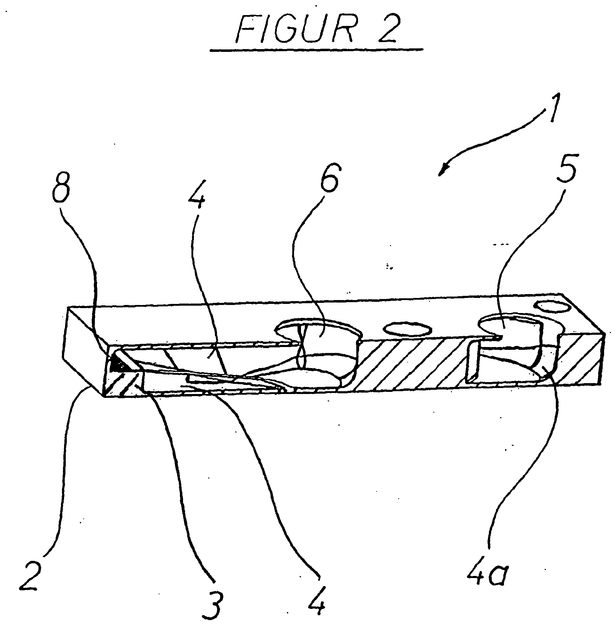

Die Figuren 1 und 2 zeigen ein Ausführungsbeispiel eines erfindungsgemäßen Mikrokühlkörpers 1.

Der Mikrokühlkörper 1 ist im wesentlichen quaderförmig ausgebildet und weist an der Oberseite im vorderen stirnseitigen Endbereich eine Montagefläche 2 für ein zu kühlendes Bauteil wie beispielsweise ein Halbleiterbauelement auf. Unterhalb der Montagefläche 2 ist im Inneren des Mikrokühlkörpers 1 eine Mikrokühlstruktur 3 angeordnet, die zusammen mit Verbindungskanälen 4, mindestens einer Zulauföffnung 5 und mindestens einer Ablauföffnung 6 einen Kühlkreislauf 7 bildet, welcher zu Kühlzwecken mit einem Kühlmedium, wie beispielsweise mit deionisiertem Wasser, durchströmt werden kann.

Die Mikrokühlstruktur 3 ist in an sich bekannter Weise aus kammförmigen Fortsätzen 8 ausgebildet, die in geringem Abstand zueinander angeordnet sind, so daß sich die Grenzflächen der kammförmigen Fortsätze 8 untereinander beeinflussen können.

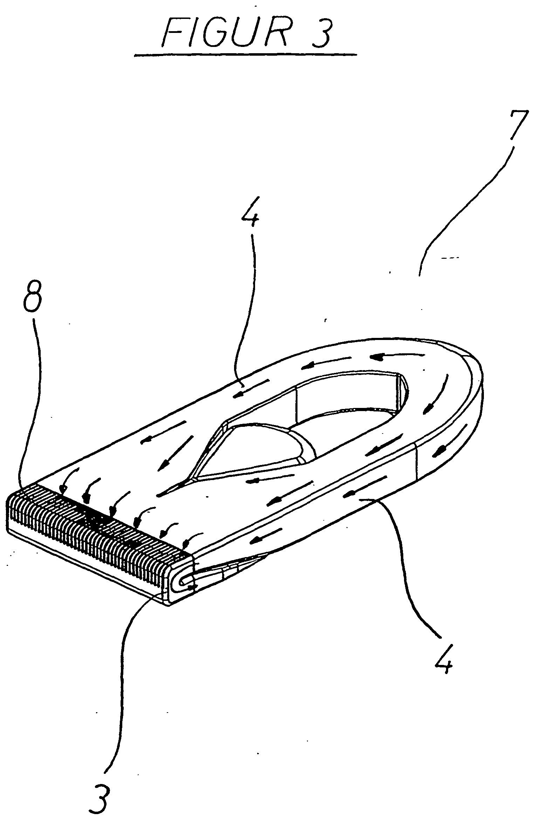

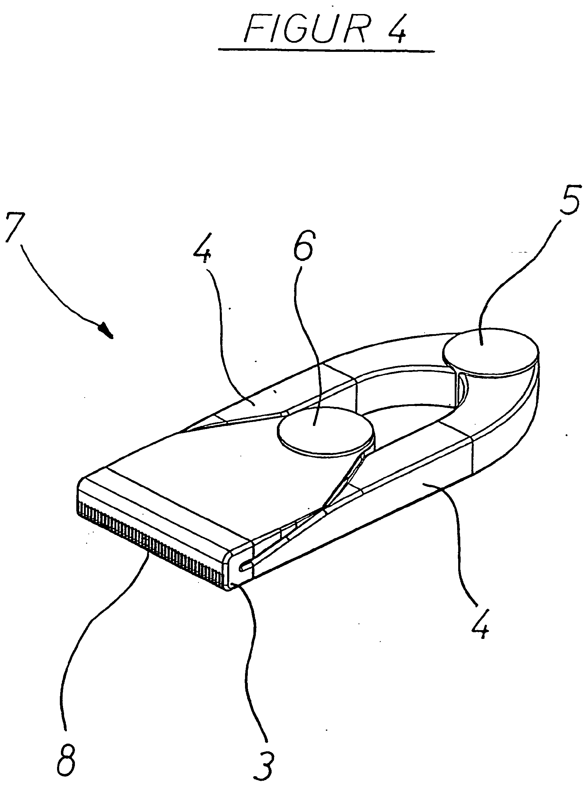

Wie in den Figuren 3 und 4 zu sehen ist, weisen die Verbindungskanäle 4 eine strömungsoptimierte Struktur in Form von abgerundeten, insbesondere ovalen Wandungen und Grenzflächen 4a auf, so daß sich in den Verbindungskanälen 4 eine nahezu laminare Strömung ausbildet. Dadurch wird ein Druckabfall in dem den Mikrokühlkörper 1 durchströmenden Kühlmedium vermindert. Zur Mikrokühlstruktur 3 hin verringert sich der Querschnitt der Verbindungskanäle 4, wodurch sich in diesem Bereich eine turbulente Strömung ausbildet. Dies hat einen verbesserten Wärmetausch zur Folge. Durch eine geeignete Strukturierung der Oberflächen der Verbindungskanäle 4 kann die Ausbildung einer turbulenten Strömung noch unterstützt werden. Ein beispielhafter Strömungsverlauf des Kühlmediums in dem Mikrokühler 1 ist in der Figur 3 durch schwarze Pfeile angedeutet.

Der in den Figuren gezeigte Mikrokühlkörper 1 soll dazu eingesetzt werden, einen Diodenlaserbarren aus Galliumarsenit mit einem Wärmeausdehnungskoeffizienten von ungefähr 6,5 zu kühlen. Der Mikrokühlkörper 1 ist daher aus Molybdän mit einem Wärmeausdehnungskoeffizienten von ungefähr 5 aufgebaut. Durch die Anpassung der Wärmeausdehnungskoeffizienten des Diodenlaserbarrens und des Materials des Mikrokühlkörpers 1 können Eigenspannungen verringert werden.

Der Mikrokühlkörper 1 wird mittels des selektiven Laserschmelzens hergestellt. Bei diesem Verfahren wird das herzustellende Bauteil zunächst entlang der Z-Ebene des Bauteils virtuell in Schnitte zerlegt, und die sich daraus ergebenden CAD-Daten in X- und Y-Richtung werden in eine Steuereinheit eingegeben. Anschließend wird ein metallisches Werkstoffpulver aus Edelstahl oder Molybdän frei von Bindemitteln und Flußmitteln mit einer vorgegebenen Schichthöhe, die einer Eindringtiefe eines in dem Verfahren eingesetzten Laserstrahls entspricht auf eine in Z-Richtung versenkbare Bodenplatte einer Prozeßkammer aufgebracht. Unter Schutzgasatmosphäre wird ein Laserstrahl entsprechend der in die Steuereinheit eingegebenen CAD-Daten auf der Pulverschicht verfahren, so daß das metallische Werkstoffpulver lokal auf Schmelztemperatur erhitzt und an der jeweiligen Auftreffstelle des Laserstrahls über seine gesamte Schichthöhe vollständig aufgeschmolzen wird. Anschließend wird die Bodenplatte um einen Betrag abgesenkt, der der Schichtdicke des eingefüllten Metallpulvers entspricht. Dann wird eine weitere Schicht aus dem metallischen Werkstoffpulver auf die bereits vorhandene, mit Laserstrahlung behandelte Metallpulverschicht aufgebracht, deren Schichtdicke wiederum der Eindringtiefe des Laserstrahls entspricht. Danach wird der Laserstrahl erneut entsprechend der in der Steuerung eingegebenen CAD-Daten des herzustellenden Mikrokühlkörpers in X- und Y-Richtung verfahren und das Material an der Auftreffstelle des Lasers wiederum über seine gesamte Schichtdicke vollständig aufgeschmolzen. Diese Vorgehensweise wird solange wiederholt, bis der Mikrokühlkörper vollständig strukturiert und aufgebaut ist.

Der Laserstrahl wird in mehreren Spuren über den vorgegebenen Bereich der Werstoffschicht so geführt, daß jede folgende Spur des Laserstrahl die vorherige Spur teilweise überlappt. Durch die Überlappung wird die Schmelze des Pulvers und die Schmelze der angrenzenden bereits erstarrten festen Kontur, die zuvor aufgeschmolzen wurde und unter der nachträglich aufgetragenen Pulverschicht liegt, zu einem gemeinsamen Schmelzbad aufgeschmolzen. Daraufhin geht das Schmelzbad eine schmelzmetallurgische Verbindung ein. Dadurch bildet sich nach der Erstarrung ein homogener Formkörper mit hoher Festigkeit und Dichtigkeit und ohne Rillen oder sonstige Übergangsstellen aus.

Wurde auf diese Weise der Mikrokühlkörper vollständig aufgebaut, so ist es anschließend lediglich notwendig, das in den inneren Strukturen zurückgebliebene Pulver zu entfernen. Dies kann beispielsweise mittels Druckluft erreicht werden oder indem der Mikrokühlkörper anschließend mit deionisiertem Wasser unter Druck durchspült wird.

## Patentansprüche

1. Mikrokühlkörper (1) mit einer Montagefläche (2) für ein zu kühlendes Bauteil, insbesondere ein Halbleiterbauelement, welcher im Inneren eine Mikrokühlstruktur (3) aufweist, die über Verbindungskanäle (4) mit mindestens einer Zulauföffnung (5) und mindestens einer Ablauföffnung (6) verbunden ist, und mit diesen einen innerhalb des Mikrokühlkörpers (1) ausgebildeten Kühlkreislauf (7) bilden, über den der Mikrokühlstruktur (3) ein Kühlmedium zuführ- bzw. aus ihr abführbar ist, **dadurch gekennzeichnet, daß** der Mikrokühlkörper (1) eine monolithische Struktur aufweist und durch selektives Laserschmelzen hergestellt ist, und wobei der Mikrokühlkörper (1) aus Edelstahl oder Molybdän gebildet ist.

2. Mikrokühlkörper (1) nach Anspruch 1, **dadurch gekennzeichnet, daß** er quaderartig ausgebildet ist.

3. Mikrokühlkörper (1) nach Anspruch 1 oder 2, **dadurch gekennzeichnet, daß** er Außenwandstärken < 400 µm aufweist.

4. Mikrokühlkörper (1) nach einem der vorherigen Ansprüche, **dadurch gekennzeichnet, daß** die Verbindungskanäle (4) eine strömungsoptimierte Struktur, insbesondere in Form von abgerundeten Wandungen und Grenzflächen (4a) aufweist, so daß sich in den Verbindungskanälen (4) eine nahezu laminare Strömung ausbildet.

5. Mikrokühlkörper (1) nach einem der vorhergehenden Ansprüche, **dadurch gekennzeichnet, daß** die Mikrokühlstruktur (3) derart ausgebildet ist, daß sich darin eine turbulente Strömung in diesem Bereich ausbildet.

6. Mikrokühlkörper (1) nach einem der vorhergehenden Ansprüche, **dadurch gekennzeichnet, daß** die Mikrokühlstruktur (1) kammförmige Fortsätze (8) aufweist.

7. Mikrokühlkörper (1) nach Anspruch 6, **dadurch gekennzeichnet, daß** die Mikrostruktur (3) derart ausgebildet ist, daß die kammförmigen Fortsätze (8) der Mikrokühlstruktur (3) in so geringem Abstand zueinander angeordnet sind, daß sich ihre Grenzflächen untereinander beeinflussen.

8. Diodenlaserbauelement mit einem aufgelöteten Diodenlaser und einem Mikrokühlkörper (1) nach einem der Ansprüche 1 bis 7.

9. Diodenlaserstack mit mindestens zwei übereinander angeordneten Diodenlaserbauelementen, die jeweils einen Mikrokühlkörper (1) nach einem der Ansprüche 1 bis 9 aufweisen, wobei die Zulauf- bzw. Ablauföffnungen (5, 6) der Mikrokühlkörper (1) jeweils über einen gemeinsamen Zulaufkanal und einen gemeinsamen Ablaufkanal für das Kühlmedium miteinander in Verbindung stehen.

## Claims

1. A micro-scale cooling element (1) having a mounting surface (2) for a device that is to be cooled, in particular a semiconductor component, which element has in the interior a micro-scale cooling structure (3) that is connected via connecting conduits (4) to at least one inflow opening (5) and at least one outflow opening (6) together building a cooling circuit within the micro-scale cooling element (1) through which a cooling medium is coveyable to and dischargeable from the micro-scale structure (3), **characterized in that** the micro-scale cooling element (1) has a monolithic structure and it is built by selective laser melting, and wherein the micro-scale cooling element (1) is made from high grade steel orfrom molybdenum.

2. The micro-scale cooling element (1) according to claim 1, **characterized in that** it is shaped cuboidally.

3. The micro-scale cooling element (1) according to claim 1 or 2, **characterized in that** it has an external wall thickness < 400um.

4. The micro-scale cooling element (1) according to any of the foregoing claims, **characterized in that** the connecting conduits (4) have a flow-optimized structure, in particular in the form of rounded walls and boundary surfaces (4a), so that an almost laminar flow is established in the connecting conduits (4).

5. The micro-scale cooling element (1) according to any of the foregoing claims, **characterized in that** the micro-scale cooling structure (3) is embodied in such a way that a turbulent flow is established therein **in that** region.

6. The micro-scale cooling element (1) according to any of the foregoing claims, **characterized in that** the micro-scale cool

7. The micro-scale cooling element (1) according to claim 6, wherein the micro-scale structure (3) is embodied in such a way that the comb-shaped extensions (8) of the micro-scale cooling structure (3) are arranged with such a small spacing from one another, that its interfaces influence each other.

8. A diode laser component having a soldered-on diode laser and a micro-scale cooling element (1) according to any of claims 1 to 7.

9. A diode laser stack having at least two diode laser components, arranged one above another, that each comprise a micro-scale cooling element (1) according to any of claims 1 to 8, the inflow and outflow openings (5, 6) of the micro-scale cooling elements (1) being respectively in communication with each other via a common inflow conduit and a common outflow conduit.

## Revendications

1. Micro dissipateur thermique (1) avec une surface montage (2) pour un composant à refroidir, notamment un composant semi-conducteur, qui présente à l'intérieur une structure de refroidissement (3), qui est reliée par des canaux de raccordement (4) avec au moins une ouverture d'alimentation (5) et au moins une ouverture d'évacuation (6), et forme avec ceux-ci un circuit de refroidissement (7) formé à l'intérieur du micro dissipateur thermique (1), par lequel un milieu de refroidissement peut être amené ou évacué du micro dissipateur thermique (1), **caractérisé en ce que** le micro dissipateur thermique (1) présente une structure monolithique et il est fabriqué par fusion sélective au laser et il est fait en acier inoxydable ou en molybdène.

2. Micro dissipateur thermique (1) selon revendication 1, **caractérisé en ce qu'**il a une forme de cube.

3. Micro dissipateur thermique (1) selon revendication 1 ou 2, **caractérisé en ce qu'**il présente des épaisseurs de paroi < 400 µm.

4. Micro dissipateur thermique (1) selon l'une des revendications précédentes, **caractérisé en ce que** les canaux de raccordement (4) présentent une structure à écoulement optimisé, notamment en forme de parois arrondies et des surfaces de séparation (4a), de manière à former un écoulement pratiquement laminaire dans les canaux de raccordement (4).

5. Micro dissipateur thermique (1) selon l'une des revendications précédentes, **caractérisé en ce que** la micro structure de refroidissement (3) est formée de telle manière qu'un écoulement turbulent se forme à l'intérieur dans cette zone.

6. Micro dissipateur thermique (1) selon l'une des revendications précédentes, **caractérisé en ce que** la micro structure de refroidissement (3) présente des prolongements en forme de peigne (8).

7. Micro dissipateur thermique (1) selon revendication 6, **caractérisé en ce que** la micro structure (3) est formée de telle manière que les prolongements en forme de peigne (8) de la micro structure de refroidissement (3) sont placés avec un espacement si fable les uns par rapport aux autres, que leurs surfaces de séparation s'influencent entre elles.

8. Composant de diode laser avec une diode laser brasée et un micro dissipateur thermique (1) selon l'une des revendications 1 à 7.

9. Pile de diode laser avec au moins deux composants de diode laser placés l'un sur l'autre, qui présentent respectivement un micro dissipateur thermique (1) selon l'une des revendications 1 à 8, sachant que les ouvertures d'alimentation et d'évacuation (5, 6) du micro dissipateur thermique (1) sont respectivement en contact l'une avec l' autre à travers un canal commun d' alimentation et un canal commun d'évacuation pour le milieu de refroidissement.
